# FASCICULE DE BREVET EUROPEEN

(11) **EP 2 985 786 B1**
(45) Date de publication et mention de la délivrance du brevet: **07.12.2016**
(21) Numéro de dépôt: 15172316.0
(22) Date de dépôt: 16.06.2015
(51) Int. Cl.: H01L 21/66, H01L 23/34

(54) **PUCE DE CIRCUIT INTÉGRÉ SANS DÉRIVE EN TEMPÉRATURE**
IC-BAUSTEIN OHNE TEMPERATURABWEICHUNG
INTEGRATED CIRCUIT CHIP WITHOUT TEMPERATURE DRIFT

(30) Priorité: 13.08.2014 FR 1457792
(43) Date de publication de la demande: 17.02.2016
(73) Titulaire: STMicroelectronics (Grenoble 2) SAS, 38000 Grenoble (FR)
(72) Inventeur: Pontarollo, Serge, 38120 Saint Egreve (FR); Maige, Philippe, 38170 Seyssinet-Pariset (FR)
(74) Mandataire: Thibon, Laurent

(56) Documents cités:
- US-A1- 2006 278 950
- "MT-037 TUTORIAL Amp Input Offset Voltage", , 1 octobre 2008 (2008-10-01), pages 1-10, XP055180596, Extrait de l'Internet: URL:http://www.analog.com/media/en/trainin g-seminars/tutorials/MT-037.pdf [extrait le 2015-03-31]
- KERSJES R ET AL: "A fast liquid flow sensor with thermal isolation by oxide-filled trenches", SENSORS AND ACTUATORS A, ELSEVIER SEQUOIA S.A., LAUSANNE, CH, vol. 47, no. 1-3, 1 mars 1995 (1995-03-01) , pages 373-379, XP027220171, ISSN: 0924-4247 [extrait le 1995-03-01]

## Description

### Domaine

La présente demande concerne des puces contenant des circuits intégrés ayant une ou plusieurs caractéristiques susceptibles de varier avec la température.

### Exposé de l'art antérieur

Certains circuits intégrés, par exemple des amplificateurs opérationnels ou des générateurs de tension de référence, sont susceptibles de présenter des dérives en température lors de leur fonctionnement, si certains de leurs paramètres ne sont pas ajustés avec une grande précision. Même si les paramètres de ces circuits sont calculés de façon telle que ces dérives devraient être évitées, les fluctuations technologiques de fabrication entraînent que les divers circuits fabriqués sur une même plaquette ou des circuits fabriqués sur des plaquettes différentes présenteront des variations technologiques telles que les circuits fabriqués présenteront des dérives en température.

A titre d'exemple de caractéristiques d'un circuit intégré susceptible de présenter des dérives en température si les paramètres de ce circuit ne sont pas ajustés avec précision, on peut mentionner la tension de décalage ou tension d'offset entre l'entrée inverseuse et l'entrée non-inverseuse d'un amplificateur opérationnel.

Ainsi, pour pouvoir fournir des circuits intégrés ne présentant pas de dérives en température, les fabricants sont amenés à effectuer des tests sur plaquette de chaque circuit fabriqué et à ajuster des paramètres des circuits pour qu'ils soient exempts de dérives en température. Cet ajustement est par exemple effectué en prévoyant dans les circuits intégrés des réseaux de résistances dont certains éléments sont déconnectés par brûlage laser (laser trimming).

Plus particulièrement, dans le cas de la tension d'offset d'un amplificateur opérationnel, des mesures sont effectuées sous pointes à plusieurs températures, couramment deux températures, et en fonction de ces mesures, on détermine la façon d'ajuster les résistances des réseaux de résistances susmentionnées. A titre d'exemple, des moyens pour ajuster la tension d'offset en fonction des mesures effectuées à diverses températures sont décrits dans le document de la société ANALOG DEVICES intitulé : MT-037 TUTORIAL disponible sur Internet à l'adresse . http://www.analog.com/static/imported-files/tutorials/MT-037.pdf.
Ceci exige, comme cela a été mentionné, d'effectuer des mesures à deux températures distinctes. Pour cela, on place la plaquette sur un support chauffant. Le support est d'abord maintenu à la température ambiante puis chauffé pour atteindre une température haute, par exemple 100°C. A chacune de ces températures, des tests sous pointes sont effectués et on peut alors mettre en oeuvre le procédé d'ajustement par laser décrit précédemment.

Une difficulté d'un tel procédé est de porter la plaquette à deux températures distinctes. En pratique, le passage au moyen d'un support chauffant d'une première température stable à une seconde température stable prend une durée de plusieurs minutes. Cette durée est loin d'être négligeable devant la durée totale de fabrication des puces et a un impact important sur le coût total de fabrication d'une plaquette.

Il existe donc un besoin de réduction de la durée de test.

US 2006/278950 A1 (TAI AKIRA [JP]) 14 décembre 2006 (2006-12-14) divulgue une puce de circuit intégré comprenant des tranchées entourant une partie critique du circuit susceptible de le rendre sensible à des variations de température, ces tranchées traversant (partiellement) la puce et des résistances chauffantes et un capteur de température placés dans ladite partie de circuit.

### Résumé

Ainsi, un mode de réalisation prévoit une puce de circuit intégré, comprenant des tranchées entourant une partie critique du circuit susceptible de le rendre sensible à des variations de température, ces tranchées traversant la puce et étant interrompues localement pour laisser passer des connexions entre ladite partie et le reste du circuit ; et des résistances chauffantes et un capteur de température placés dans ladite partie de circuit.

Selon un mode de réalisation, le capteur de température est une diode à jonction PN.

Selon un mode de réalisation, les résistances chauffantes sont des résistances diffusées.

Selon un mode de réalisation, la partie critique est entourée d'un double réseau de tranchées, ces tranchées étant formées de façon à définir des bras reliant la partie critique du circuit au reste de la puce.

Un mode de réalisation prévoit un procédé de réalisation d'une puce de circuit intégré, le circuit intégré comprenant une partie critique susceptible de le rendre sensible à des variations de température, comprenant les étapes consistant à identifier la partie critique du circuit intégré ; regrouper les éléments de cette partie critique dans une partie isolée entourée de tranchées ; disposer dans la partie isolée des résistances chauffantes et un capteur de température ; effectuer des tests de la puce à diverses températures ; et effectuer un ajustement d'éléments de la partie critique de la puce.

Selon un mode de réalisation, le procédé comprend en outre les étapes consistant à assembler la plaquette contenant les puces sur un support par l'intermédiaire d'une couche isolante interrompue aux emplacements de la partie critique de la puce ; et revêtir la puce d'un capot avec interposition d'une couche isolante interrompue au-dessus de la partie critique de la puce.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus d'un mode de réalisation d'une puce comprenant un circuit intégré corrigé en température ;
la figure 1B est une vue en coupe selon le plan BB de la figure 1A ; et
la figure 2 est une vue de dessus d'un mode de réalisation particulier d'une puce comprenant un circuit intégré corrigé en température.

Comme cela est habituel dans la représentation des circuits intégrés, les figures ne sont pas tracées à l'échelle.

### Description détaillée

On cherche ici à réaliser un test du type décrit ci-dessus à des températures distinctes en évitant la durée longue actuellement nécessaire à la mise à deux températures distinctes d'une plaquette.

Pour cela, on propose ici une topologie différente des circuits intégrés contenus dans une puce. Plus particulièrement, on propose d'identifier les éléments critiques d'un circuit intégré qui, par suite de fluctuations technologiques, sont susceptibles de rendre le circuit intégré sensible à des variations de température. Ces éléments critiques sont regroupés dans une partie de la puce qui est isolée thermiquement du reste de cette puce. On prévoit également d'incorporer dans cette partie isolée de la puce des résistances chauffantes et un détecteur de température. Ainsi, la partie isolée de la puce qui a une faible surface par rapport à la surface totale de la puce peut être chauffée très rapidement et des tests du type de ceux décrits précédemment peuvent être effectués en un temps bref. Comme on le verra ci-après, ce temps bref peut être de 10 à 100 millisecondes, par exemple 20 ms, au lieu d'une durée de l'ordre de 5 à 15 minutes, par exemple 10 minutes, dans le cas où on utilise une plaquette posée sur un support chauffant.

On notera qu'un avantage de cette durée très brève de passage d'une température à une autre pour les éléments critiques d'une puce susceptibles d'induire des dérives en température entraîne que l'on pourra effectuer des tests à plus de deux températures, par exemple trois ou quatre, ce qui améliore encore la qualité des résultats du test et des corrections effectuées pour rendre le circuit stable en température.

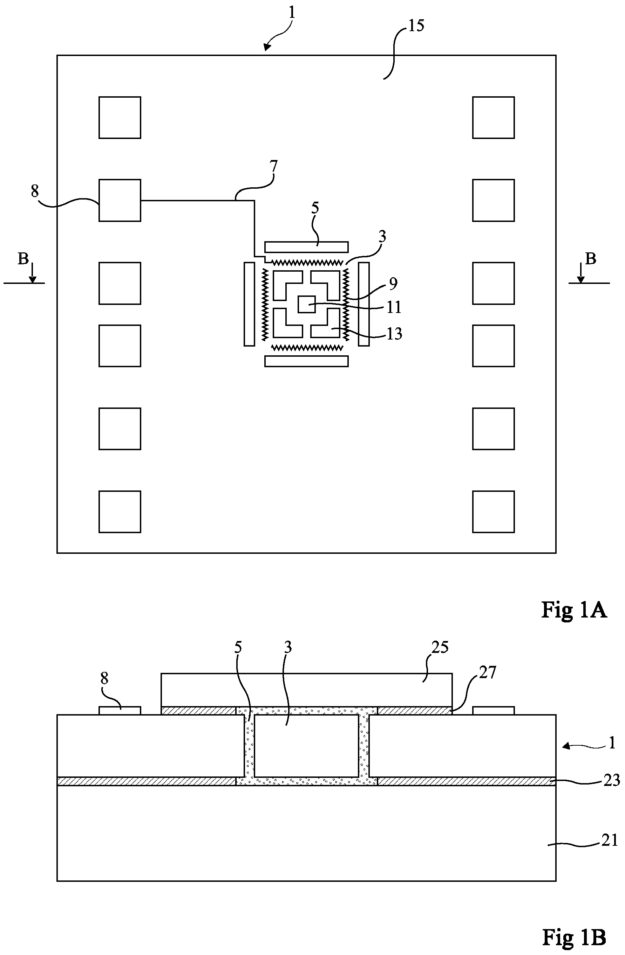

Les figures 1A et 1B sont une vue de dessus et une vue en coupe d'un mode de réalisation d'une puce 1 d'une plaquette semiconductrice.

Dans ces figures, une seule puce est représentée. Toutefois, on comprendra que, pendant les opérations de test, cette puce n'est pas découpée et fait encore partie d'une plaquette semiconductrice. Dans le circuit intégré, contenu dans la puce, les éléments critiques, c'est-à-dire ceux dont des variations dues à des fluctuations de paramètres technologiques peuvent entraîner que le circuit intégré résultant présentera des dérives en température, sont regroupés dans une partie 3 de cette puce, représentée à titre d'exemple comme étant une partie centrale de la puce. Cette partie 3 est entourée de tranchées traversantes 5. On a représenté ici quatre tranchées 5 définissant sensiblement un carré. Les coins des tranchées ne se rejoignent pas de façon que la partie isolée 3 reste mécaniquement solidaire du reste de la puce et que des conducteurs de connexion 7 puissent s'étendre de la partie isolée 3 de la puce vers des plots de connexion 8 ou d'autres éléments de la puce. La partie isolée 3 de la puce comprend notamment des résistances chauffantes 9 et un détecteur de température 11. On a également illustré sous forme de blocs 13 les éléments critiques du circuit intégré. Dans le cas où le circuit intégré contenu dans la puce 1 est un amplificateur opérationnel, les inventeurs ont noté que les parties de cet amplificateur opérationnel susceptibles de provoquer des dérives de la tension d'offset en fonction de la température correspondent essentiellement à l'étage d'entrée de cet amplificateur opérationnel. Les blocs 13 correspondent alors aux éléments de cet étage d'entrée. Les autres éléments de l'amplificateur opérationnel sont regroupés dans la partie restante 15 de la puce.

A titre d'exemple, le capteur de température 11 est une diode qui, quand elle est traversée par un courant constant, présente une tension qui varie de -2 mV/°C.

A titre d'exemple, les résistances chauffantes 9 sont des résistances formées par des zones diffusées dans le semiconducteur, par exemple du silicium, de la puce.

La figure 1B représente plus en détail un exemple de montage d'une puce, ce montage étant effectué de préférence alors que les puces sont encore assemblées en une plaquette. La plaquette de silicium, de préférence une plaquette amincie, est montée sur un support 21, avec interposition d'une couche isolante 23, par exemple en oxyde de silicium, entre les puces, cette couche isolante étant interrompue au niveau de la partie centrale de la puce. De plus, un capot 25, également de préférence en silicium est montée sur la face supérieure de la plaquette, avec interposition d'une couche isolante 27, la couche isolante 27 étant interrompue en regard de la partie centrale de la puce. Ainsi, il reste dans les tranchées 5, sous la partie centrale de la puce et au-dessus de la partie centrale de la puce, un vide améliorant l'isolement thermique de la puce. Dans des réalisations pratiques, on pourra préférer laisser en place le vide seulement au niveau des tranchées 5 et revêtir également les surfaces supérieure et inférieure de la puce d'une couche d'un matériau isolant.

A titre d'exemple de valeurs numériques, on considère une puce carrée dont les dimensions latérales sont comprises entre 0,5 et 1,5 mm, par exemple 1 mm. On considère le cas où la partie isolée est également de forme carrée. Dans le cas d'un amplificateur opérationnel, cette partie centrale pourra avoir des dimensions latérales comprises entre 250 et 350 µm, par exemple 300 µm. Les tranchées pourront avoir une largeur comprise entre 20 et 50 µm, par exemple 30 µm.

Ceci montre bien que les dimensions de la partie critique entourée de tranchées du circuit intégré sont très faibles par rapport aux dimensions totales de la puce (surface au moins 10 fois plus petite dans l'exemple ci-dessus). Il en résulte que le temps de chauffe de cette partie isolée peut être très court par rapport au temps nécessaire pour chauffer une plaquette complète. A titre d'exemple, comme cela a été indiqué précédemment, ce temps de chauffe peut être compris entre 10 et 100 ms, par exemple 20 ms, alors que, on le rappellera, le temps de chauffe d'une plaquette sur un support chauffant pour atteindre une température stable est de l'ordre de la dizaine de minutes.

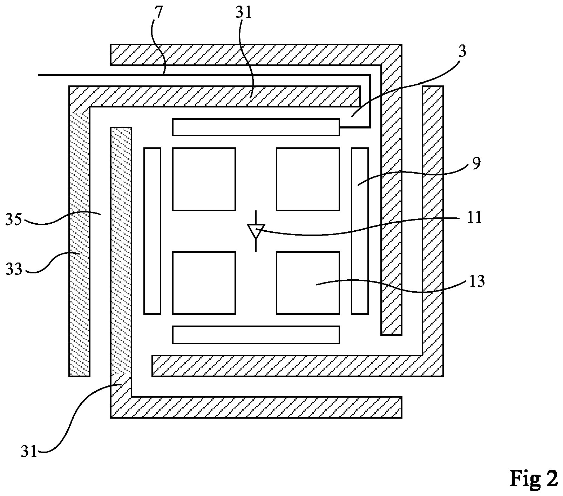

La figure 2 est une vue de dessus d'un mode de réalisation particulier d'une puce telle que décrite précédemment. On retrouve en figure 2 de mêmes éléments qu'en figures 1A et 1B désignés par de mêmes références, à savoir une partie centrale 3, des résistances chauffantes 9, un capteur de température 11 représenté par le schéma d'une diode, et des éléments critiques 13 d'un circuit intégré. Dans ce mode de réalisation, la partie centrale est entourée d'une double tranchée. Chaque tranchée comprend une partie 31 délimitant la partie centrale de la puce et une partie 33 orthogonale à la partie 31 et s'étendant parallèlement à une autre partie 31 orthogonale à la première, et à l'extérieur de celle-ci. Ainsi, ces tranchées délimitent des bras 35 reliant la partie centrale de la puce au reste de la puce. C'est sur ces bras 35 que pourront s'étendre des connexions 7 reliant des éléments de la partie isolée de la puce à des plots de la puce ou à d'autres éléments de la partie périphérique de la puce.

L'homme de l'art notera que la surface occupée par un circuit intégré dans la réalisation décrite ici est légèrement plus grande que la surface d'une puce classique non munie de tranchées d'isolement thermique d'une partie du circuit intégré. Toutefois, des calculs économiques ont montré que les coûts résultant de cette augmentation de surface sont largement compensés par le gain résultant de la réduction des durées de tests sous pointes d'une plaquette de circuit intégré.

## Revendications

1. Puce de circuit intégré, comprenant :
des tranchées (5 ; 31, 33) entourant une partie critique (3) du circuit susceptible de le rendre sensible à des variations de température, ces tranchées traversant la puce (1) et étant interrompues localement pour laisser passer des connexions (7) entre ladite partie et le reste du circuit ; et
des résistances chauffantes (9) et un capteur de température (11) placés dans ladite partie de circuit.

2. Puce selon la revendication 1, dans laquelle le capteur de température est une diode à jonction PN.

3. Puce selon la revendication 1 ou 2, dans laquelle les résistances chauffantes (9) sont des résistances diffusées.

4. Puce selon l'une quelconque des revendications 1 à 3, dans laquelle la partie critique (3) est entourée d'un double réseau de tranchées (31, 33), ces tranchées étant formées de façon à définir des bras reliant la partie critique du circuit au reste du circuit.

5. Procédé de réalisation d'une puce (1) de circuit intégré, le circuit intégré comprenant une partie critique susceptible de le rendre sensible à des variations de température, comprenant les étapes suivantes :
identifier la partie critique du circuit intégré ;
regrouper les éléments de cette partie critique dans une partie isolée entourée de tranchées, ces tranchées traversant la puce (1) et étant interrompues localement pour laisser passer des connexions (7) entre ladite partie et le reste du circuit ;
disposer dans la partie isolée des résistances chauffantes et un capteur de température ;
effectuer des tests de la puce à diverses températures ; et
effectuer un ajustement d'éléments de la partie critique de la puce.

6. Procédé selon la revendication 5, comprenant en outre les étapes consistant à :
assembler une plaquette contenant des puces (1) sur un support (21) par l'intermédiaire d'une couche isolante interrompue aux emplacements de la partie critique du circuit ; et
revêtir la puce d'un capot (25) avec interposition d'une couche isolante interrompue au-dessus de la partie critique du circuit.

## Patentansprüche

1. Ein integrierter Schaltkreischip, der Folgendes aufweist:
Einschnitte (5; 31, 33), die einen kritischen Anteil (3) des Schaltkreises befähigen, ihn empfindlich für Temperaturänderungen zu machen, wobei solche Einschnitte den Chip (1) kreuzen und lokal unterbrochen sind, um Verbindungen (7) zwischen dem Anteil und dem Rest von dem Schaltkreis durchzulassen; und
Heizwiderstände (9) und einen Temperatursensor (11), der in dem Schaltkreisanteil platziert ist.

2. Chip nach Anspruch 1, wobei der Temperatursensor eine PN-Übergangsdiode ist.

3. Chip nach Anspruch 1 oder 2, wobei die Heizwiderstände (9) diffundierte Widerstände sind.

4. Chip nach einem der Ansprüche 1 bis 3, wobei der kritische Anteil (3) von einem doppelten Netzwerk von Einschnitten (31, 33) umgeben ist, wobei die Einschnitte gebildet sind, Arme zu definieren, die den kritischen Anteil des Schaltkreises mit dem Rest des Schalkreises verbinden.

5. Ein Verfahren zum Bilden eines integrieren Schaltkreischips (1), wobei der integrierte Schaltkreis einen kritischen Anteil aufweist, der fähig ist, ihn für Temperaturänderungen empfindlich zu machen, wobei das Verfahren die Folgenden Schritte aufweist:
Identifizieren des kritischen Anteils des integrierten Schaltkreises;
Zusammenbringen der Elemente des kritischen Anteils in einem isolierten Anteil, der von Einschnitten umgeben ist, die Einschnitte kreuzen den Chip (1) und sind lokal unterbrochen, um Verbindungen (7) zwischen dem Anteil und dem Rest von dem Schaltkreis durchzulassen;
Anordnen von Heizwiderständen und eines Temperatursensors in dem isolierten Anteil;
Testen des Chips bei verschiedenen Temperaturen; und
Abgleichen von Elementen des kritischen Anteils des Chips.

6. Verfahren nach Anspruch 5, das ferner die Folgenden Schritte aufweist:
Zusammensetzen eines Wafers, der Chips (1) auf einer Unterstützung (21) über einer Isolationsschicht enthält, die an den Orten des kritischen Anteils unterbrochen ist, und
Beschichten des Chips mit einem Deckel (25) mit einer eingefügten Isolationsschicht, die über dem kritischen Anteil des Schaltkreises unterbrochen ist.

## Claims

1. An integrated circuit chip, comprising:
trenches (5; 31, 33) surrounding a critical portion (3) of the circuit capable of making it sensitive to temperature variations, such trenches crossing the chip (1) and being locally interrupted to let connections (7) pass between said portion and the rest of the circuit; and
heating resistors (9) and a temperature sensor (11) placed in said circuit portion.

2. The chip of claim 1, wherein the temperature sensor is a PN-junction diode.

3. The chip of claim 1 or 2, wherein the heating resistors (9) are diffused resistors.

4. The chip of any of claims 1 to 3, wherein the critical portion (3) is surrounded with a double network of trenches (31, 33), said trenches being formed to define arms connecting the critical portion of the circuit to the rest of the circuit.

5. A method of forming an integrated circuit chip (1), the integrated circuit comprising a critical portion capable of making it sensitive to temperature variations, comprising the steps of:
identifying the critical portion of the integrated circuit;
gathering the elements of this critical portion in an insulated portion surrounded with trenches, said trenches crossing the chip (1) and being locally interrupted to let connections (7) pass between said portion and the rest of the circuit ;
arranging in the insulated portion heating resistors and a temperature sensor;
testing the chip at various temperatures; and
adjusting elements of the critical portion of the chip.

6. The method of claim 5, further comprising the steps of:
assembling a wafer containing chips (1) on a support (21) via an insulating layer interrupted at the locations of the critical portion of the circuit; and
coating the chip with a cap (25) with an interposed insulating layer interrupted above the critical portion of the circuit.
